# EUROPÄISCHE PATENTSCHRIFT

(11) **EP 2 307 898 B1**
(45) Veröffentlichungstag und Bekanntmachung des Hinweises auf die Patenterteilung: **13.02.2013**
(21) Anmeldenummer: 09777254.5
(22) Anmeldetag: 17.07.2009
(51) Int. Cl.: G01R 33/09, G07D 7/04

(54) **MESSVORRICHTUNG ZUM MESSEN MAGNETISCHER EIGENSCHAFTEN UND HERSTELLUNGSVERFAHREN FÜR EINE SOLCHE MESSVORRICHTUNG**
MEASURING APPARATUS FOR MEASURING MAGNETIC PROPERTIES, AND METHOD FOR PRODUCING SUCH A MEASURING APPARATUS
DISPOSITIF DE MESURE POUR LA MESURE DE PROPRIÉTÉS MAGNÉTIQUES ET PROCÉDÉ DE FABRICATION POUR UN TEL DISPOSITIF DE MESURE

(30) Priorität: 17.07.2008 DE 102008033579
(43) Veröffentlichungstag der Anmeldung: 13.04.2011
(73) Patentinhaber: MEAS Deutschland GmbH, 44227 Dortmund (DE)
(72) Erfinder: MEISENBERG, Armin, 44227 Dortmund (DE); BARTOS, Axel, 45731 Waltrop (DE)
(74) Vertreter: Tilmann, Max Wilhelm
(86) Internationale Anmeldenummer: PCT/EP2009/005196
(87) Internationale Veröffentlichungsnummer: WO 2010/006801

(56) Entgegenhaltungen:
- EP-A1- 1 701 176

## Beschreibung

Die Erfindung betrifft eine Messvorrichtung zum Messen magnetischer Eigenschaften der Umgebung der Messvorrichtung sowie ein Herstellungsverfahren für eine derartige Messvorrichtung und nimmt die Priorität der deutschen Patentanmeldung 10 2008 033 579.7 in Anspruch.

Aus dem Stand der Technik sind Messvorrichtungen zum Identifizieren von Geldscheinen mit darauf aufgedruckten magnetischen Mustern bekannt. Eine solche Messvorrichtung wird beispielsweise in EP 1 729 142 A1 beschrieben. Nachteilig an der dort beschriebenen Messvorrichtung Ist eine Messungenauigkeit, die dann auftritt, wenn das zu ermittelnde magnetische Muster über eine Lücke in der dort vorgesehenen Sensorzelle geführt wird. Die bekannte Messvorrichtung weist im Bereich ihrer Lücken zwischen den einzelnen Sensorelementen der Sensorzeile eine geringe Messgenauigkeit auf.

Aus EP 1 701 176 A1 ist eine Messvorrichtung zum Messen magnetischer Eigenschaften der Umgebung der Mussvorrichtung mit einer Sensorzeile aus mindestens zwei in einer sich in eine Zeilenrichtung erstreckenden Zeile angeordneten magnetoresistiven Sensorelementen und einer Stützfeldvorrichtung bekannt, die ein magnetisches Stützfeld erzeugt, das eine in Zeilenrichtung weisenden Magnetiekikomponente aufweist, deren Feldstärke in Zeilenrichtung variiert. In den Figuren der EP 1 701 176 A1 sind Stützfelder dargestellt, die eine In zeilenrichtung weisende Magnetfeldkomponente aufweisen, deren Feldstärkenverlauf in Zeilenrichtung an zumindest zwei in Zeilenrichtung nacheinander angeordneten Sensorrändern der die Sensorzelle bildenden Sensorelemente keinen Nulldurchgang und/oder kein Maximum oder Minimum aufweist. Die EP 1 701 176 A1 lehrt die Zahl der Magnete pro Sensorelement in der Sensorzeile zu erhöhen und mindestens zwei Magnete pro Sensorelement vorzusehen, um den Abstand der Punkte, an denen eine Magnetfeldlinie senkrecht in das Sensorelement eindringt, bzw. senkrecht aus diesem heraus tritt in Zeilenrichtung möglichst gering zu halten.

Vor diesem Hintergrund lag der Erfindung die Aufgabe zugrunde, eine Messvorrichtung zum Messen magnetischer Eigenschaften der Umgebung der Messvorrichtung vorzuschlagen, mit der diese magnetischen Eigenschaften der Umgebung der Messvorrichtungen präziser gemessen werden können. Ferner war es Aufgabe der Erfindung, ein Herstellungsverfahren für eine derartige Messvorrichtung vorzuschlagen.

Die Erfindung geht von dem Grundgedanken aus, die Messvorrichtung mit einer Stützfeldvorrichtung zu versehen, die ein magnetisches Stützfeld erzeugt, das eine In Zeilenrichtung weisende Magnetfeldkomponente aufweist, deren Feldstärke in der Sensorzeile In Zeilenrichtung variiert Es wurde erkannt, dass Sensorzeilen aus fertigungstechnischen Gründen Lücken zwischen den einzelnen Sensorelementen aufweisen und dass es von Vorteil ist, die Empfindlichkeit des jeweiligen Sensorelements im Bereich seines Rands zu erhöhen. Dadurch entsteht die Möglichkeit, magnetische Eigenschaften in der Lücke zwischen den Rändern zweier Sensorelemente genauer zu messen.

Es hat sich gezeigt, dass hierfür eine Stützfeldvorrichtung besonders geeignet ist, deren in Zeilenrichtung weisende Magnetfeldkomponente des magnetischen Stützfeldes einen Feldstärkenverlauf in Zeilenrichtung aufweist, der an zumindest zwei in Zeilenrichtung nacheinander angeordneten Sensorrändern der die Sensorzeile bildenden Sensorelemente keinen Nulldurchgang und/oder kein Maximum oder Minimum aufweist.

Es wurde erkannt, dass die Empfindlichkeit eines Sensorelements an seinem Rand steigt, wenn der Feldstärkenverlauf der in Zeilenrichtung weisenden Magnetfeldkomponente des magnetischen Stützfeldes nahe dem Sensorrand des Sensorelements einen Nulldurchgang aufweist. Es kann für die Empfindlichkeit des Sensorelements nachteilig sein, wenn der Feldstärkenverlauf der in Zeilenrichtung weisenden Magnetfeldkomponente des magnetischen Stützfelds an dem Sensorrand des Sensorelementes ein Maximum oder Minimum aufweist. Um die Vorteile der Erfindung zu erreichen, reicht es aus, wenn der Feldstärkenverlauf der in Zeilenrichtung weisenden Magnetfeldkomponente des magnetischen Stützfelds an zumindest zwei in Zeilenrichtung nacheinander angeordneten Sensorrändern der die Sensorzeile bildenden Sensorelemente keinen Nulldurchgang aufweist. Besonders bevorzugt ist es dabei, wenn der Feldstärkenverlauf der in Zeilenrichtung weisenden Magnetfeldkomponente des magnetischen Stützfelds zwischen zwei in Zeilenrichtung nacheinander angeordneten Sensorrändern der die Sensorzeile bildenden Sensorelemente einen Nulldurchgang aufweist. Ebenso reicht es zum Erreichen der Vorteile der Erfindung aus, wenn der Feldstärkenverlauf der in Zeilenrichtung weisenden Magnetfeldkomponente des magnetischen Stützfelds an zumindest zwei in Zeilenrichtung nacheinander angeordneten Sensorrändern der die Sensorzeile bildenden Sensorelemente kein Maximum oder Minimum aufweist. In einer bevorzugten Ausführungsform weist der Feldstärkenverlauf der in Zeilenrichtung weisende Magnetfeldkomponente des magnetischen Stützfelds an zumindest zwei in Zeilenrichtung nacheinander angeordneten Sensorrändern der die Sensorzeile bildenden Sensorelemente weder einen Nulldurchgang auf, noch hat sie an diesen zwei in Zeilenrichtung nacheinander angeordneten Sensorrändern der die Sensorzeile bildenden Sensorelemente ein Maximum oder ein Minimum.

In einer bevorzugten Ausführungsform weist der Feldstärkenverlauf der in Zeilenrichtung weisenden Magnetfeldkomponente des magnetischen Stützfelds im gesamten Bereich eines Sensorelements keinen Nulldurchgang auf.

Die Sensorzeile der Messvorrichtung weist mindestens zwei in einer Zeile angeordnete magnetoresistive Sensorelemente auf. Die Länge der Sensorzeile und damit die Zahl der verwendeten magnetoresistiven Sensorelemente hängt von der durchzuführenden Messung ab. Zur Messung von Euro-Banknoten kann eine Sensorzeile beispielsweise mehr als 10, insbesondere bevorzugt mehr als 20, beispielsweise 28 Sensorelemente aufweisen. Zur Bildung der Sensorzeile sind die Sensorelemente in einer Zeile angeordnet. Insbesondere bevorzugt liegen die Längsmittelachsen aller Sensorelemente auf einer Linie. Es ist aber auch denkbar, dass die Sensorelemente einer einzelnen Zeile bezogen auf eine in Zeilenrichtung weisende Achse unterschiedlich angeordnet sind, so dass die Längsmittelachsen der einzelnen Sensorelemente nicht mehr alle auf einer Linie liegen. Insbesondere bevorzugt sind derart angeordnete Sensorelemente jedoch so angeordnet, dass sich die einzelnen Sensorelemente teilweise überlappen.

In einer bevorzugten Ausführungsform sind mehrere Sensorelemente zu einer Baugruppe zusammengefasst, beispielsweise auf einer gemeinsamen Trägerstruktur angeordnet. Eine solche Baugruppe wird nachfolgend als Sensor bezeichnet. Ein Sensor kann beispielsweise 2, 3, 4 oder mehr Sensorelemente aufweisen. Es ist aber auch möglich, dass ein Sensor durch ein einziges Sensorelement gebildet wird.

In einer bevorzugten Ausführungsform ist der Sensor, auf dem das, bzw. die Sensorelemente angeordnet sind, als Chip ausgebildet. Der Chip kann dann auf einer Trägerplatte ("Board") der Messvorrichtung angeordnet werden. Insbesondere bevorzugt sind mehrere, insbesondere vier, Sensorelemente auf einem Chip angeordnet. Die Sensorelemente sind auf dem Chip vorzugsweise äquidistant zueinander und den Rädern des Chips angeordnet. Der Chip kann unmittelbar mit der der Trägerplatte verbunden sein, beispielsweise durch eine sog. "Chip-on-board"-oder "Flip-Chip"-Technologie. Alternativ kann der Sensor zu dem Chip ein Gehäuse, insbesondere bevorzugt ein Kunststoffgehäuse, aufweisen, das mittels Surface-Mount-Technologie elektrisch und mechanisch mit der Trägerplatte verbunden wird.

In einer bevorzugten Ausführungsform sind die Sensorelemente in Zeilenrichtung äquidistant angeordnet. In einer besonders bevorzugten Ausführungsform beträgt der Abstand eines ersten Sensorelements zu einem benachbarten Sensorelement, bezogen auf den Abstand zwischen den Mittelpunkten der beiden Sensorelemente, zwischen 1 und 10 mm, vorzugsweise zwischen 2 und 5 mm und insbesondere bevorzugt 3,5 mm. In einer besonders bevorzugten Ausführungsform weist ein Chip zwei in Zeilenrichtung nach einander angeordnete Sensorelemente auf und weist - ohne Gehäuse - eine Länge von 1,5 bis 9 mm, vorzugsweise von 2 bis 3 mm und insbesondere bevorzugt von 2,5 mm in Zeilenrichtung auf. In einer bevorzugten Ausführungsform beträgt der Abstand von einem Rand eines Chips zu dem Rand des benachbarten Chips weniger als 1,5 mm und insbesondere bevorzugt weniger als 1,1 mm.

In einer alternativen Ausführungsform sind die Sensorelemente derart angeordnet, dass der Abstand zwischen zwei Rändern zweier benachbarter Sensorelemente, die auf einem Chip angeordnet sind kleiner ist, als der Abstand zwischen zwei Rändern benachbarter Sensorelemente, die nicht auf einem Chip angeordnet sind. Der Abstand zwischen zwei Chips ist in der Regel durch die Technologie vorgegeben, mit der ein Chip auf einer Trägerplatte verbunden werden kann. Diese Technologien benötigen in der Regel mehr Raum als der Raum, der benötigt wird, um zwei magnetoresistive Sensorelemente auf einem Chip anzuordnen. Die Empfindlichkeit der Messvorrichtung kann deshalb dadurch gesteigert werden, dass sowohl die Anbringung der Sensorelemente auf dem Chip als auch die Anbringung der Chips auf dem Board so dicht wie nach der jeweils eingesetzten Technologie möglich erfolgt.

Die Herstellung der Sensorelemente auf den Chips erfolgt bevorzugt mit den Methoden der Planartechnik, Halbleitertechnik oder Mikrosystemtechnik.

Die Sensorelemente in der Sensorzeile sind magnetoresistive Sensorelemente. Insbesondere kann das Sensorelement den "anisotropen" magnetoresistiven Effekt (AMR-Effekt) oder den "gigantischen" magnetoresistiven Effekt (GMR-Effekt) aufweisen. Das Sensorelement kann allerdings auch andere Effekte aufweisen, wie beispielsweise den Giant Magnetoimpedance (GMI), den Tunnel Magnetoresistance Effekt (TMR) oder den Hall-Effekt.

Die erfindungsgemässe Messvorrichtung kann zum Messen magnetischer Eigenschaften der Umgebung der Messvorrichtung eingesetzt werden. Unter magnetischen Eigenschaften der Umgebung der Messvorrichtung werden insbesondere die Magnetfeldstärke eines magnetischen Felds in der Umgebung der Messvorrichtung, die Feldrichtung eines magnetischen Felds in der Umgebung der Messvorrichtung oder aber auch beispielsweise die Änderung der Feldstärke bzw. Feldrichtung eines magnetischen Felds in der Umgebung der Messvorrichtung verstanden. Beispielsweise wird als magnetische Eigenschaft der Umgebung die Änderung der Feldstärke und der Feldrichtung des die Messvorrichtung umgebenden magnetischen Feldes verstanden, wenn sich dieses Feld durch Überlagerung eines Feldes ändert, das von einem magnetischen Muster einer Banknote erzeugt wird. In einer bevorzugten Ausführungsform wird die Sensorzeile so ausgelegt, dass sie nur räumliche und/oder zeitliche Änderungen der magnetischen Eigenschaften der Umgebung der Messvorrichtung detektiert.

Die erfingdungsgemäß eingesetzte Stützfelkivorrichtung kann aus einem oder mehreren Bauteilen, beispielsweise Permanentmagneten bestehen. Die Stützfeidvorrichtung kann aber auch aus einer Vielzahl von Komponenten bestehen, wie sie beispielsweise bei der Erzeugung von Magnetfeldern mittels elektromagnetischer Spulen notwendig sind.

Die Stützfeldvorrichtung erzeugt ein Stützfeld, dessen in Zeilenrichtung weisende Magnetfeldkomponente einen Feldstärkenverlauf in Zeilenrichtung aufweist, der zwischen zumindest zwei Sensorelemente der die Sensorzelle bildenden Sensorelemente ein Minimum aufweist. Bei der erfindungsgemäßen Messvorrichtung sind mindestens zwei Chips mit jeweils zwei auf den Chips angeordneten Sensorelementen vorgesehen, wobei die Stützfeldvorrichtung ein Stützfeld erzeugt, dessen in Zeilenrichtung weisende Magnetfeldkomponente einen Feldstärkenverlauf in Zeilenrichtung aufweist, der zwischen den Chips einen Nulldurchgang und zwischen den Sensorelementen eines Chips ein Maximum, bzw. ein Minimum aufweist.

In einer bevorzugten Ausführungsform ist eine Stützfeldanordnung vorgesehen, die im wesentlichen nur ein im Sensorelement wirkendes Feld erzeugt. Eine solche Ausführungsform kann zur Detektion hartmagnetischer Materialien zweckmäßig sein. Insbesondere bevorzugt wird eine Stützfeldanordnung eingesetzt, bei dem die senkrecht zur Ebene der Sensorelemente weisende Magnetfeldkomponente einen Feldstärkeverlauf aufweist, der in die von der Stützfeldvorrichtung zu den Sensorelementen weisenden Richtung nach den Sensorelementen rasch abnimmt, beispielsweise oberhalb der In diese Richtung weisenden Sensorelement-Oberfläche in einem Abstand von 2mm von der Sensoroberfläche in diese Richtung einen Wert von ca. 50% seiner maximalen Feldstärke aufweist, Indem ein Messobjekt mit Hartmagneten über eine solche Messvorrichtung geführt wird, wird diesem Stützfeld das Feld der Hartmagneten des Messobjekts überlagert. Die mit der Überlagerung verbundene Änderung des an den Sensorelementen anliegenden Gesamtmagnetfelds kann durch die Sensorelemente erfasst werden.

In einer bevorzugten Ausführungsform ist eine Stützfeldanordnung vorgesehen, die ein weit über das Sensorelement hinauswirkendes Feld erzeugt, welches die Detektion sowohl hart- als auch weichmagnetischer Materialien ermöglicht. Insbesondere bevorzugt wird eine Stützfeldanordnung eingesetzt, bei dem die senkrecht zur Ebene der Sensorelemente weisende Magnetfeldkomponente einen Feldstärkeverlauf aufweist, der in die von der Stützfeldvorrichtung zu den Sensorelementen weisenden Richtung nach den Sensorelementen nur gering abnimmt, beispielsweise oberhalb der in diese Richtung weisenden Sensorelement-Oberfläche in einem Abstand von 2mm von der Sensoroberfläche in diese Richtung einen Wert von 80% seiner maximalen Feldstärke aufweist. Indem ein Messobjekt mit hart- als auch weichmagnetischern Materialien Messobjekt über eine solche Messvorrichtung geführt wird, wird das Stützfeld durch die Anwesenheit derartiger Materialien deformiert. Diese Deformation des anliegenden Magnetfelds kann von den Sensorelementen zur Erzeugung eines Sensorsignals detektiert werden. Insbesondere bevorzugt weist das Stützfeld in dem Bereich der Messvorrichtung, in dem das Messobjekt während der Messung angeordnet ist, eine magnetische Feldstärke auf, die deutlich höher ist, vorzugsweise mindestens dreifach höher, als die Koerzitivfeldstärke der zu detektierenden magnetischen Strukturen.

Die Verbesserung der Messgenauigkeit wird bereits erreicht, wenn an mindestens zwei in Zeilenrichtung nacheinander angeordneten Sensorrändern der Feldstärkenverlauf in Zeilenrichtung keinen Nulldurchgang und/oder kein Maximum oder Minimum aufweist. Dabei müssen diese in Zeilenrichtung nacheinander angeordneten Sensorränder nicht einander unmittelbar folgen. Die Erfolge der Erfindung werden auch erreicht, wenn der Feldstärkenverlauf in Zeilenrichtung an einem beliebigen Rand eines beliebigen ersten Sensorelements der Sensorzeile und an einem beliebigen Rand eines beliebigen zweiten Sensorelements der Sensorzeile keinen Nulldurchgang und/oder kein Maximum oder Minimum aufweist, solange es sich um Ränder handelt, die über die gesamte Ausdehnung der Sensorzeile in Zeilenrichtung nacheinander angeordnet sind.

Es kann bei einer Ausführungsform der erfindungsgemäßen Messvorrichtung vorgesehen sein, dass der Feldstärkenverlauf in Zeilenrichtung an einem Sensorrändern der die Sensorzeile bildenden Sensorelemente einen Nulldurchgang und/oder ein Maximum oder Minimum aufweist. Die erfindungsgemäßen Vorteile werden dann an anderen Sensorelementrändern erzielt.

In einer besonders bevorzugten Ausführungsform der erfindungsgemäßen Messvorrichtung wird ein Stützfeld erzeugt, bei dem der Feldstärkenverlauf in Zeilenrichtung an allen in Zeilenrichtung nacheinander angeordneten Sensorrändern der die Sensorzeile bildenden Sensorelemente keinen Nulldurchgang und/oder kein Maximum oder Minimum aufweist. Beispielsweise wird das Stützfeld durch jeweils einen Magneten pro Sensorelement erzeugt. Dieser Magnet kann im einfachsten Fall während der Herstellung des Sensorelements unmittelbar auf dem Sensor aufgebracht werden.

Das Stützfeld kann zeitvariant sein, beispielsweise impulsartig aufgeprägt werden. In einer bevorzugten Ausführungsform ist das Stützfeld jedoch zeitinvariant und liegt stets in der gleichen Weise an. Dies vereinfacht insbesondere den Aufbau der Messvorrichtung, da zur Erzeugung des Stützfelds auf Permanentmagneten zurückgegriffen werden kann.

In einer bevorzugten Ausführungsform ist der Feldstärkenverlauf in Zeilenrichtung periodisch und hat in einer besonders bevorzugten Ausführungsform ein ganzzahliges Vielfaches oder einen ganzzahligen Bruchteil der Periode des bevorzugt gleichbleibenden Abstands zwischen den Sensorelementen der Sensorzeile. In einer besonders bevorzugten Ausführungsform weist die Stützfeldvorrichtung am Anfang und am Ende der Sensorzeile Anordnungen von Magneten auf, die auch an den Enden der Zeile zu einem im wesentlichen periodischen Verlauf der Feldstärke in Zeilenrichtung über die Sensorzeile führen. Dies kann erreicht werden, indem die Magnetanordnung, bevorzugt mindesten 3 weitere, über das Ende der Sensorzeile hinausragende Pole besitzt. In einer bevorzugten Ausführungsform werden zur Verkürzung der Gesamtbaulänge die Randeffekte durch eine Modifikation der Geometrie oder Magnetisierung oder Anordnung der äußeren Magnete vermindert, beispielsweise in dem die Länge des Magneten um ca. 30% der Magnetperiode verkürzt wird.

In einer bevorzugten Ausführungsform weist die Stützfeldvorrichtung eine Zeile nebeneinander, insbesondere in Zeilenrichtung der Sensorelemente nebeneinander angeordneter Magnete auf. Die Magnetisierung der Magneten dieser Zeile kann alternierend sein, so dass die Magnetisierung eines Magneten entgegengesetzt zu der Magnetisierung seiner benachbarten Magneten ist. Die in einer Zeile nebeneinander angeordneten Magneten können jedoch auch die gleiche Magnetisierung aufweisen. In diesem Fall sind die Magneten besonders bevorzugt in Zeilenrichtung beanstandet voneinander angeordnet. Die in einer Zeile nebeneinander angeordneten Magneten können jedoch auch wechselnde Magnetisierung auf weisen, die das sensorelementseitige Feld verstärken und das rückseitige Feld schwächen.

In einer bevorzugten Ausführungsform, insbesondere bei in Zeilenrichtung nebeneinander angeordneten Magneten, bei denen die Magnetisierung der Magneten von einem zum benachbarten Magneten alterniert, sind die Magneten unmittelbar aneinander angrenzend angeordnet. Dies führt zu einem homogenen Verlauf des Stützfelds.

Die Stützfeldvorrichtung kann insbesondere aus plastikgebundenem Hartferrit oder aus Seltenerdmagneten hergestellt werden.

In einer bevorzugten Ausführungsform ist eine Stützfeldvorrichtung mit einer Zeile nebeneinander angeordneten Magneten, bei denen die Magnetisierung alterniert, im Verhältnis zur Sensorzeile so angeordnet, dass der Übergang von einem Magneten zum benachbarten Magneten in der Mitte zumindest eines Sensorelements, bezogen auf seine Ausdehnung in Zeilenrichtung angeordnet ist. Dadurch wird auf einfache Weise erreicht, dass der Feldstärkenverlauf in Zeilenrichtung an nacheinander angeordneten Sensorrändern der die Sensorzeile bildenden Sensorelemente keinen Nulldurchgang und/oder kein Maximum oder Minimum aufweist.

In einer bevorzugten Ausführungsform weist die Stützfeldvorrichtung Permanentmagneten auf. Dadurch kann die Stützfeldfunktion einfach aufgebaut werden.

In einer bevorzugten Ausführungsform kann die Messvorrichtung zwei nebeneinander angeordnete Sensorzeilen, beispielsweise zwei in einer Messrichtung, in die das zu messende Messobjekt gegebenenfalls bewegt wird, nebeneinander angeordnete Sensorzeilen aufweisen. Hierdurch kann die Messgenauigkeit weiter erhöht werden. Ergänzend oder alternativ kann die Messvorrichtung zwei nebeneinander angeordnete Stützfeldvorrichtungen aufweisen. Dadurch kann der Feldverlauf des Stützfelds homogenisiert werden. Die begrenzte räumliche Ausdehnung der Stützfeldmagnete kann insbesondere bei der Verwendung räumlich ausgedehnter Gradientensensoren zu unerwünschten Sensoreigenschaften, wie beispielsweise Empfindlichkeitsschwankungen führen. Zu Vermeidung dieser Nachteile wird in einer bevorzugten Ausführung durch die Verwendung mindestens einer weiteren beabstandeten Anordnung von Stützmagneten eine Homogenisierung des Stützfeldes quer zur Zeilenrichtung erreicht.

In einer besonders bevorzugten Ausführungsform sind zwei in Zeilenrichtung nach einander angeordnete Sensorzeilen vorgesehen, die zur Ermittlung unterschiedlicher Eigenschaften eingesetzt werden. Es ist bekannt, dass Geldscheine sogenannte hartmagnetische und weichmagnetische Muster aufweisen. Zur Erkennung der hartmagnetischen Muster ist es notwendig, den Geldschein vorzumagnetisieren. Zur Erkennung der weichmagnetischen Muster ist ein starkes Stützfeld erforderlich. Die gleichzeitige Erkennung der hartmagnetischen Muster und der weichmagnetischen Muster kann durch das Stützfeld einer ersten Sensorzeile erfolgen, über die der Geldschein zunächst geführt wird. Das Stützfeld dieser Zeile ermöglicht also die Erkennung der weichmagnetischen Muster und dient gleichzeitig der Vormagnetisierung der hartmagnetischen Strukturen. Wird der Geldschein anschließend über eine zweite Sensorzeile geführt, so kann diese zweite Sensorzeile separat das hartmagnetische Muster erkennen. In einer bevorzugten Ausführungsform weisen sowohl die erste Sensorzeile als auch die zweite Sensorzeile Stützfeldvorrichtungen auf. Der Vorteil der separaten Erkennung von weichmagnetischen und hartmagnetischen Strukturen liegt in der verbesserten Echtheitsprüfung. Gleichzeitig kann auf die Verwendung eines separaten Vormagnetisierungsmagneten verzichtet werden.

In einer bevorzugten Ausführungsform weist die erfindungsgemäße Messvorrichtung einen Vormagnetisierungsmagnet auf, der vor der Sensorzeile angeordnet ist. Mit diesem Vormagnetisierungsmagnet kann eine Magnetisierung eines Messobjekts mit hartmagnetischem Muster erfolgen, über den das Messobjekt zunächst geführt wird. Wird das Messobjekt anschließend über eine Sensorzeile geführt, so kann diese Sensorzeile das hartmagnetische Muster erkennen. In einer bevorzugten Ausführungsform ist der Vormagnetisierungsmagnet derart ausgebildet und angeordnet, dass er in zumindest einem, vorzugweise in allen Sensorelementen ein magnetisches Feld erzeugt, dass im wesentlichen nur eine senkrecht zur Ebene der Sensorelemente weisende Richtung hat. Dadurch kann vermieden werden, dass das Feld des Vormagnetisierungsmagnets die Empfindlichkeit der Sensorelemente beeinflusst.

In einer besonders bevorzugten Ausführungsform weist die Messvorrichtung keine Vormagnetisierungsmagnete auf. Mit einer solchen Messvorrichtung kann eine Magnetisierung des Messobjekts beispielsweise dadurch erzeugt werden, dass das Stützfeld in dem Bereich der Messvorrichtung, in dem das Messobjekt während der Messung angeordnet ist, eine magnetische Feldstärke auf, die deutlich höher ist, als die Koerzitivfeldstärke der zu detektierenden magnetischen Strukturen.

Die erfindungsgemäße Vorrichtung kann zusammen mit einem Vorverstärker in einem Gehäuse integriert sein. Ergänzend oder alternativ kann das Gehäuse Vorkehrungen gegen Abrieb oder dergleichen aufweisen.

Das erfindungsgemäße Herstellungsverfahren für eine erfindungsgemäße Messvorrichtung sieht vor, dass eine Stützfeldvorrichtung mit einer Zeile nebeneinander angeordneter Magneten relativ zu der Sensorzeile ausgerichtet wird. Dazu wird ein elektrischer Leiter im Bereich der Sensorzeile angeordnet. Der elektrische Leiter ist derart ausgebildet, dass er bei Stromdurchfluss ein Feld erzeugt, das in der Sensorzeile ein von der Lage der Stützfeldvorrichtung abhängiges, von der Lage der Sensorzeile relativ zu dem elektrischen Leiter in erster Näherung unabhängiges Signal erzeugt. Damit kann an Hand dieses Signals erkannt werden, ob die Stützfeldvorrichtung in der gewünschten Lage relativ zur Sensorzeile angeordnet ist. Mit Hilfe einer derartigen Vorrichtung ist es auch möglich die Empfindlichkeit der einzelnen Sensorelemente zu kontrollieren.

Die erfindungsgemäße Messvorrichtung kann Anwendung finden bei der Mustererkennung auf Wertdokumenten, wie beispielsweise Banknoten, Schecks, die häufig mit einem weichmagnetischen und/oder hartmagnetischen Muster versehen sind. Ebenso kann die erfindungsgemäße Messvorrichtung bei dem Erkennen von so genannten Tags oder bei der Erkennung magnetischer Barcodes eingesetzt werden. Ebenso kann die erfindungsgemäße Messvorrichtung bei der Materialprüfung, wie beispielsweise beim Feststellen von Fehlstellen, Löchern oder Rissen eingesetzt werden. Ebenfalls kann die erfindungsgemäße Messvorrichtung Anwendung bei magnetischen Arrays in Biochips oder der so genannten "Lab-on-a-chip"-Technologie Einsatz finden, beispielsweise zum Nachweis magnetischer Beads oder zur Homogenisierung der Empfindlichkeitsverteilung des Arrays.

Nachfolgend wird die Erfindung an Hand einer lediglich ein Ausführungsbeispiel darstellende Zeichnung näher erläutert. Darin zeigen:
- Fig. 1: die erfindungsgemäße Messvorrichtung in einer schematischen Darstellung in einer Draufsicht,
- Fig. 2: den Aufbau einer Stützfeldvorrichtung einer erfindungsgemäßen Messvorrichtung, bei dem ein weitausgreifendes Stützfeld erzeugt wird, in einer schematischen Darstellung in einer Seitenansicht und
- Fg.3: den Aufbau einer Stützfeldvorrichtung einer erfindungsgemäße Messvorrichtung, bei dem ein auf das Sensorelement lokal begrenztes Stützfeld erzeugt wird, in einer schematischen Darstellung in einer Seitenansicht
- Fig. 4: den Aufbau einer Stützfeldvorrichtung einer erfindungsgemäße Messvorrichtung, bei dem ein auf das Sensorelement lokal begrenztes Stützfeld erzeugt wird, in einer schematischen Darstellung in einer Seitenansicht
- Fig. 5: ein Stützfeldvorrichtung in einer Schnittansicht, bei der ein divergenter Feldverlauf einer einreihigen Anordnung von Stützfeldmagneten im Bereich zweier Sensorelemente dargestellt ist und
- Fig. 6: eine Anordnung mit zwei Stützfeldvorrichtungen in einer Schhittansicht, bei der ein homogener, paralleler Feldverlauf einer zweireihigen Anordnung von Stützfeldmagneten im Bereich zweier Sensorelemente dargestellt ist.

Die erfindungsgemäße Messvorrichtung zum Messen magnetischer Eigenschaften in der Umgebung der Messvorrichtung weist nebeneinander angeordnete magnetoresistive Sensorelemente 1 auf. Die Sensorelemente 1 sind in zwei parallel zueinander angeordneten Zeilen 4a, 4b angeordnet. Mehrere magnetoresistive Sensorelemente 1 sind auf einem Sensorchip 2 zusammengefasst. Der Sensorchip 2 bildet mit einem Gehäuse einen Sensor 3, der auf einer nicht näher dargestellten Trägerplatte der Messvorrichtung angeordnet ist.

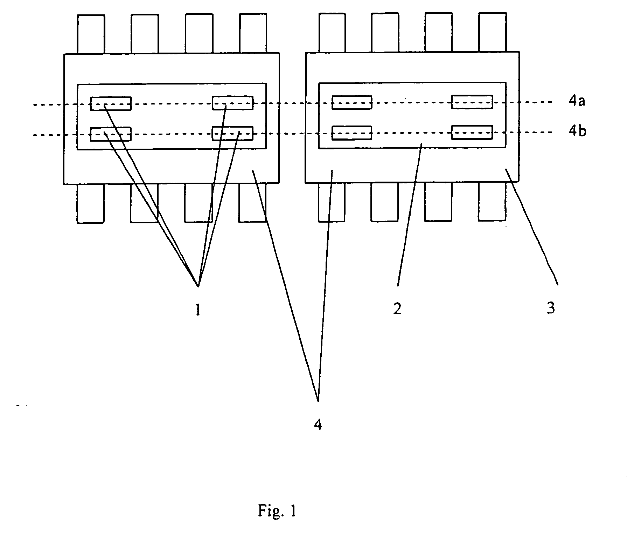

Die erfindungsgemäße Messvorrichtung weist in der Darstellung gemäß Fig. 1 mindestens zwei nebeneinander angeordnete Chips 2 auf. Die Chips 2 sind derart nebeneinander angeordnet, dass die Abstände aller Sensorelemente 1 zueinander in einer Sensorzeile 4a, 4b gleich sind.

Die Länge der Sensorzeile und damit die Zeile der magnetoresistiven Sensorelemente 1 hängt von der durchzuführenden Messung ab. Insbesondere hängt die Anzahl der verwendeten Sensorchips 2 von der Messaufgabe ab, also im wesentlichen von der Breite des zu vermessenden Objekts und der Größe des Sensorchips 2. Zur Messung von Euro-Banknoten kann eine Sensorzeile beispielsweise mehr als 10, insbesondere bevorzugt mehr als 20, vor allem 28 Sensorelemente 1 aufweisen.

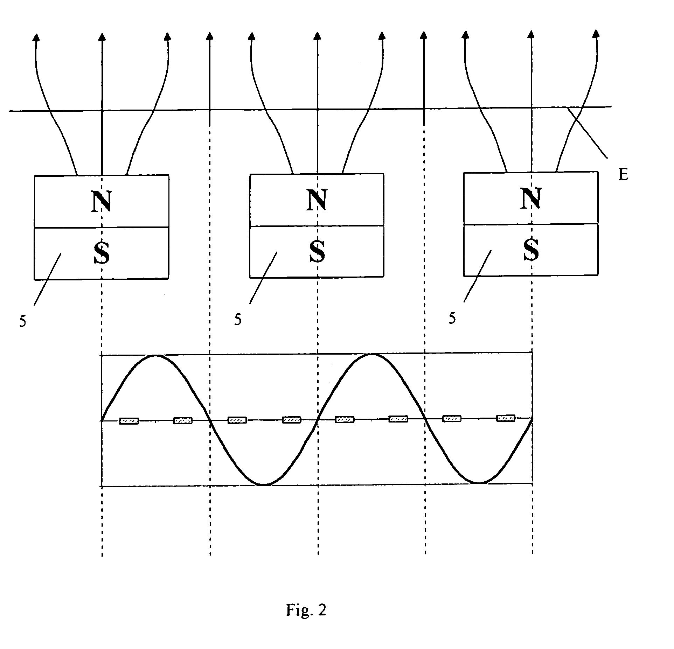

In den Fig. 2 bis 4 sind mögliche Bauformen einer Stützfeldvorrichtung dargestellt, mit der ein Magnetfeld erzeugt werde kann, das eine in Zeilenrichtung weisende Magnetfeldkomponente aufweist, deren Feldstärke in der Sensorzeile in Zeilenrichtung variiert. In den Figuren 2 bis 4 symbolisiert die Linie E die senkrecht zur Papierebene stehende Ebene, in der die Sensorelemente 1 angeordnet sind. Die in der Ebene E nicht näher dargestellten Sensorelemente 1 bilden eine Sensorzeile, die von rechts nach links verläuft.

Die Stützfeldvorrichtung wird durch mehrere Magnete 5 gebildet, die in den in den Fig. 2 bis 4 dargestellten Ausführungsformen unterhalb der Ebene E angeordnet sind, unterhalb im Bezug auf den Bereich der Messvorrichtung, in dem sich das Messobjekt während der Messung befindet (in der Darstellung der Fig. 2 bis 4 und für das Ausführungsbeispiel der Fig. 2 bis 4 liegt dieser Bereich oberhalb der Ebene E).

In der in Fig. 2 dargestellten Ausführungsform sind die Magnete 5 gleich ausgerichtet. Der jeweilige Nordpol der Magnete weist nach oben. Wie man den in Fig. 2 dargestellten Feldlinien entnehmen kann, breitet sich das Stützfeld unter anderem von den Polen nach oben aus. Dabei ist es in der Mitte des jeweiligen Pols senkrecht nach oben ausgerichtet. Aufgrund der Symmetrie der Anordnung ist das Stützfeld auf der Mittellinie zwischen zwei Magneten 5 wiederum senkrecht nach oben ausgerichtet, während es zwischen der Mitte des Pols und der Mittellinie zwischen zwei Magneten 5 einen von der senkrecht nach oben weisenden Richtung abweichende Richtung und somit eine in Zeilenrichtung weisende Magnetfeldkomponente aufweist, deren Feldstärke von null unterschiedlich ist. Der Verlauf dieser in Zeilenrichtung in Zeilenrichtung weisenden Magnetfeldkomponente ist in dem in Fig. 2 enthaltenen Graph dargestellt. In diesem Graph ist zur besseren Orientierung die Lage der in dem Graph symbolisch als Rechtecke dargestellten Sensorelemente wiedergegeben.

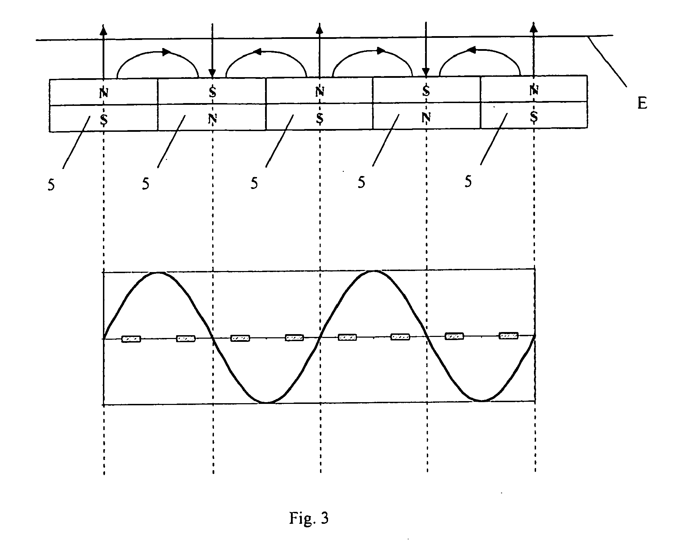

In der in Fig. 3 dargestellten Ausführungsform sind die Magnete 5 alternierend ausgerichtet. Wie man den in Fig. 3 dargestellten Feldlinien entnehmen kann, breitet sich das Stützfeld in der Mitte des jeweiligen Pols senkrecht nach oben aus. Zwischen der Mitte des jeweiligen Pols und der Mitte des jeweils benachbarten Pols breitet sich das Stützfeld in der in Fig. 3 dargestellten Weise aus. Damit weist das Stützfeld eine in Zeilenrichtung weisende Magnetfeldkomponente auf, deren Feldstärke von null unterschiedlich ist. Der Verlauf dieser in Zeilenrichtung in Zeilenrichtung weisenden Magnetfeldkomponente ist in dem in Fig. 3 enthaltenen Graph dargestellt.

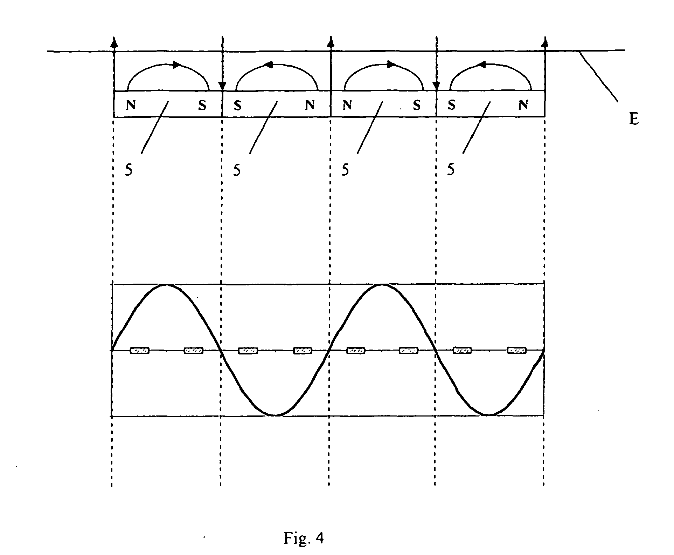

In der in Fig. 4 dargestellten Ausführungsform sind die Magnete 5 alternierend ausgerichtet. Wie man den in Fig. 4 dargestellten Feldlinien entnehmen kann, breitet sich das Stützfeld an der Seite des jeweiligen Pols senkrecht nach oben aus. Zwischen dieser Seite des jeweiligen Pols und der anderen Seite des jeweiligen Magneten 5 breitet sich das Stützfeld in der in Fig. 4 dargestellten Weise aus. Damit weist das Stützfeld eine in Zeilenrichtung weisende Magnetfeldkomponente auf, deren Feldstärke von null unterschiedlich ist. Der Verlauf dieser in Zeilenrichtung in Zeilenrichtung weisenden Magnetfeldkomponente ist in dem in Fig. 4 enthaltenen Graph dargestellt.

Wie man den in den Fig. 2 bis 4 enthaltenen Graphen entnehmen kann, erzeugt die Stützfeldvorrichtung im Bereich der Sensorzeile 4a, 4b ein in Zeilenrichtung variierendes periodisches magnetisches Stützfeld. Man erkennt, dass der Feldstärkeverlauf in Zeilenrichtung im Bereich der Ränder der Sensorelemente 1 weder einen Nulldurchgang noch ein Maximum oder Minimum aufweist. Bei den in den Fig 2 bis 4 gezeigten Ausführungsform weist der Feldstärkeverlauf in der Mitte eines Sensorchips ein Maximum, bzw. ein Minimum auf und zwischen zwei Sensorchips einen Nulldurchgang.

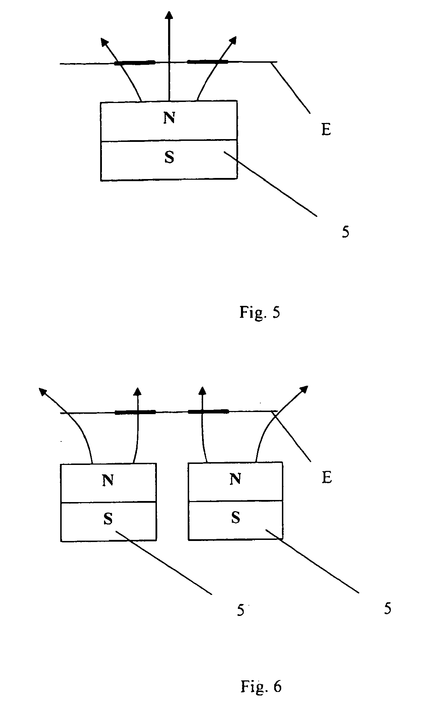

In den Fig. 5 und 6 wird dargestellt, wie durch parallele Anordnung zweier Reihen von Stützfeldmagneten 5 in der Sensorzeile ein homogeneres Feld erzeugt werden kann. Die in Fig. 5 dargestellte Stützfeldvorrichtung besteht aus einer Reihe von einzelnen Stützfeldmagneten, wobei sich in der Darstellung der Fig. 5 die Reihe der Magnete senkrecht zur Blattebene erstreckt. Die in den Fig. 5 und 6 dargestellte Bauform hat zwei parallel nebeneinander angeordnete Sensorzeilen, die sich senkrecht zur Blattebene erstrecken. Anhand der in Fig. 5 dargstellten Feldlinien erkennt man, dass das Stützfeld in der Ebene der Sensorzeilen in den dargestellten Sensorelementen eine Feldkomponente aufweist, die in der Darstellung der Fig. 5 und 6 nach rechts, bzw. links weist. Gemäß der in Fig. 6 dargestellten, bevorzugten Ausführungsform sind zwei Stützfeldvorrichtungen vorgesehen, die parallel zu einander ausgerichtet sind. Anhand der in Fig. 6 dargstellten Feldlinien erkennt man, dass das Stützfeld in der Ebene der Sensorzeilen in den dargestellten Sensorelementen im wesentlichen nur eine Feldkomponente senkrecht zur Ebene der Sensorelemente aufweist.

## Patentansprüche

1. Messvorrichtung zum Messen magnetischer Eigenschaften der Umgebung der Messvorrichtung mit einer Sensorzeile aus mindestens zwei in einer sich in eine Zeilenrichtung erstreckenden Zeile angeordneten magnetoresistiven Sensorelementen (1) und einer Stützfeldvorrichtung, die ein magnetisches Stützfeld erzeugt, das eine in Zeilenrichtung weisende Magnetfeldkomponente aufweist, deren Feldstärke in Zeilenrichtung variiert, wobei dieser Feldstärkenverlauf in Zeilenrichtung an, zumindest zwei In Zeilenrichtung nacheinander angeordneten Sensorrändern der die Sensorzeile bildenden Sensorelemente (1) keinen Nulldurchgang und/oder kein Maximum oder Minimum aufweist, **dadurch gekennzeichnet, dass** mindestens zwei Chips mit jeweils zwei auf den Chips angeordneten Sensorelementen vorgesehen sind, wobei die Stützfeldvorrichtung ein Stützfeld erzeugt, dessen In Zellenrichtung weisende Magnetfeldkamponente einen Feldstärkenverlauf in Zeilenrichtung aufweist, der zwischen den Chips einen Nulldurchgang und in Zeilenrichtung zwischen den Sensorelementen eines Chips ein Maximum, bzw. ein Minimum aufweist.

2. Messvorrichtung nach Anspruch 1, **dadurch gekennzeichnet, dass** der Feldstärkenverlauf in Zeilenrichtung an jedem Sensorrand der die Sensorzeile bildenden Sensorelemente (1) keinen Nulldurchgang und/oder kein Maximum oder Minimum aufweist.

3. Messvorrichtung nach einem der Ansprüche 1 oder 2, **dadurch gekennzeichnet, dass** das Stützfeld zeitinvariant ist.

4. Messvorrichtung nach einem der Anspruche 1 bis 3, **dadurch gekennzeichnet, dass** der Feldstärkenverlauf in Zeilenrichtung mindestens zwei Maxima und ein Minimum aufweist.

5. Messvorrichtung nach einem der Anspruche 1 bis 4, **dadurch gekennzeichnet**, das der Feldstärkenverlauf in Zeilenrichtung im Bereich der Zeile periodisch ist.

6. Messvorrichtung nach einem der Ansprüche 1 bis 5, **dadurch gekennzeichnet, dass** der Feldstärkenverlauf in Zeilenrichtung in der Mitte zumindest eines Sensorelements (1), bezogen auf seine räumlichen Erstreckung in Zeilenrichtung, ein Maximum oder ein Minimum aufweist.

7. Messvorrichtung nach einem der Ansprüche 1 bis 6, **dadurch gekennzeichnet, dass** die Stützfeldvorrichtung eine Zeile nebeneinander angeordneter Magneten (5) aufweist, wobei die Magnetisierung eines Magneten (5) entgegengesetzt zu der Magnetisierung seiner benachbarten Magneten (5) ist.

8. Messvorrichtung nach einem der Ansprüche 1 bis 6, **dadurch gekennzeichnet, dass** die Stützfeldvorrichtung eine Zeile nebeneinander angeordneter Magneten (5) aufweist, wobei die Magnetisierung eines Magneten (5) parallel zu der Magnetisierung seiner benachbarten Magneten (5) ist.

9. Messvorrichtung nach Anspruch 7 oder 8, **dadurch gekennzeichnet, dass** die Magneten (5) unmittelbar aneinandergrenzen.

10. Messvorrichtung nach einem der Ansprüche 7 bis 9, **dadurch gekennzeichnet, dass** die Zeile der nebeneinander angeordneten Magneten (5) im Verhältnis zur Sensorzeile so angeordnet ist, dass der Übergang von einem Magneten zum benachbarten Magneten nicht in der Mitte zumindest eines Sensorelements (1), bezogen auf seine Ausdehnung in Zeilenrichtung, angeordnet ist.

11. Messvorrichtung nach einem der Ansprüche 1 bis 10, **dadurch gekennzeichnet, dass** ein einzelner Magnet mit lokal variierender Magnetisierungsverteilung verwendet wird.

12. Messvorrichtung nach einem der Ansprüche 1 bis 11, **dadurch gekennzeichnet, dass** die Stützfeldvorrichtung Permanentmagneten aufweist.

13. Messvorrichtung nach einem der Ansprüche 1 bis 12, **gekennzeichnet durch** mindestens zwei nebeneinander angeordneten Sensorzeilen.

14. Messvorrichtung nach einem der Ansprüche 1 bis 13, **gekennzeichnet durch** mindestens zwei nebeneinander angeordnete Stützfeldvorrichtungen.

15. Messvorrichtung nach einem der Ansprüche 1 bis 14, **gekennzeichnet durch** mindestens zwei nacheinander angeordneten Sensorzeilen.

16. Messvorrichtung nach einem der Ansprüche 1 bis 15, **Dadurch gekennzeichnet, dass** die Sensorelemente (1) derart angeordnet sind, dass die Sensorsignale von lokalen, im Nahbereich der Sensorelemente (1) erzeugten Feldgradienten bestimmt wird, nicht jedoch von homogenen Feldern.

17. Messvorrichtung nach einem der Ansprüche 1 bis 16, **dadurch gekennzeichnet, dass** der Feldstärkenverlauf in Zeilenrichtung an zumindest einem Sensorelement durch einen Magnet erzeugt wird, der unmittelbar auf einem Chip aufgebracht ist, auf dem das Sensorelement angeordnet ist.

18. Herstellungsverfahren für eine Messvorrichtung nach einem der Ansprüche 1 bis 17, bei der die Stützfeldvorrichtung mit einer Zeile nebeneinander angeordneter Magneten relativ zu der Sensorzeile ausgerichtet wird, **gekennzeichnet durch** das Anordnen eines elektrischen Leiters in der Nähe der Sensorzeile, wobei der elektrische Leiter derart ausgebildet ist, dass er bei Stromdurchfluss ein Feld erzeugt, das in einem Sensorelement der Sensorzeile ein von der Lage der Stützfeldvorrichtung abhängiges, von der Lage der Sensorzeile relativ zu dem elektrischen Leiter in erster Näherung unabhängiges Signal erzeugt.

## Claims

1. A measuring device for measuring magnetic properties of the surroundings of the measuring device with a sensor row made up of at least two magnetoresistive sensor elements (1) arranged in a row extending in a row direction, and a supporting-field device, which generates a magnetic supporting field, which has a magnetic field component pointing in the row direction, the field strength of which varies in the row direction, wherein this field strength curve in the row direction does not have a zero crossing and/or does not have a maximum or minimum on at least two sensor edges of the sensor elements (1) forming the sensor row, which sensor edges are arranged one after the other in the row direction, **characterised in that** at least two chips are provided with two sensor elements arranged on the chips in each case, wherein the supporting-field device generates a supporting field, the magnetic field component of which, which component points in the row direction, has a field strength curve in the row direction which has a zero crossing between the chips and has a maximum or a minimum in the row direction between the sensor elements of a chip.

2. The measuring device according to Claim 1, **characterised in that** the field strength curve in the row direction does not have a zero crossing and/or does not have a maximum or minimum at every sensor edge of the sensor elements (1) forming the sensor row.

3. The measuring device according to one of the Claims 1 or 2, **characterised in that** the supporting field is time-invariant.

4. The measuring device according to one of Claims 1 to 3, **characterised in that** the field strength curve in the row direction has at least two maxima and one minimum.

5. The measuring device according to one of Claims 1 to 4, **characterised in that** the field strength curve in the row direction is periodic in the region of the row.

6. The measuring device according to one of Claims 1 to 5, **characterised in that** the field strength curve in the row direction has a maximum or a minimum in the centre of the at least one sensor element (1) with respect to the spatial extent thereof in the row direction.

7. The measuring device according to one of Claims 1 to 6, **characterised in that** the supporting-field device has a row of magnets (5) arranged next to one another, wherein the magnetisation of a magnet (5) is opposite to the magnetisation of the magnet (5) adjacent thereto.

8. The measuring device according to one of Claims 1 to 6, **characterised in that** the supporting-field device has a row of magnets (5) arranged next to one another, wherein the magnetisation of a magnet (5) is parallel to the magnetisation of the magnet (5) adjacent thereto.

9. The measuring device according to Claim 7 or 8, **characterised in that** the magnets (5) are directly adjacent to one another.

10. The measuring device according to one of Claims 7 to 9, **characterised in that** the row of the magnets (5) arranged next to one another is arranged in such a manner with respect to the sensor row that the transition from one magnet to the adjacent magnet is not arranged in the centre of the at least one sensor element (1) with respect to the extent thereof in the row direction.

11. The measuring device according to one of Claims 1 to 10, **characterised in that** an individual magnet with locally varying magnetisation distribution is used.

12. The measuring device according to one of Claims 1 to 11, **characterised in that** the supporting-field device has permanent magnets.

13. The measuring device according to one of Claims 1 to 12, **characterised by** at least two sensor rows arranged next to one another.

14. The measuring device according to one of Claims 1 to 13, **characterised by** at least two supporting-field devices arranged next to one another.

15. The measuring device according to one of Claims 1 to 14, **characterised by** at least two sensor rows arranged one after the other.

16. The measuring device according to one of Claims 1 to 15, **characterised in that** the sensor elements (1) are arranged in such a manner that the sensor signals are determined by local field gradients generated in the vicinity of the sensor elements (1), not however by homogeneous fields.

17. The measuring device according to one of Claims 1 to 16, **characterised in that** the field strength curve in the row direction on at least one sensor element is generated by a magnet which is deposited directly on a chip on which the sensor element is arranged.

18. A production method for a measuring device according to one of Claims 1 to 17, in which the supporting-field device is orientated relatively to the sensor row using a row of magnets arranged next to one another, **characterised by** the arrangement of an electrical conductor in the vicinity of the sensor row, wherein the electrical conductor is constructed in such a manner that it generates a field when current flows through it, which field generates a signal in a sensor element of the sensor row which is dependent on the position of the supporting-field device and independent of the position of the sensor row relative to the electrical conductor in a first approximation.

## Revendications

1. Dispositif de mesure pour mesurer les caractéristiques magnétiques de l'environnement du dispositif de mesure, avec une ligne de détection composée d'au moins deux éléments de détection magnétorésistifs (1) disposés sur une ligne qui s'étend dans une direction de ligne et un dispositif de champ de soutien qui génère un champ magnétique de soutien qui présente une composante de champ magnétique orientée dans la direction de ligne, dont l'intensité de champ varie dans la direction de ligne, cette variation d'intensité de champ dans la direction de ligne ne présentant pas de passage par zéro et/ou pas de maximum ou de minimum à au moins deux bords de détection des éléments de détection (1) formant la ligne de détection qui sont disposés l'un à la suite de l'autre dans la direction de ligne, **caractérisé en ce qu'**au moins deux puces sont prévues, avec deux éléments de détection disposés sur chaque puce, le dispositif de champ de soutien générant un champ de soutien dont la composante de champ magnétique orientée dans la direction de ligne présente une variation d'intensité de champ dans la direction de ligne qui présente un passage par zéro entre les puces et un maximum ou un minimum dans la direction de ligne entre les éléments de détection d'une puce.

2. Dispositif de mesure selon la revendication 1, **caractérisé en ce que** la variation d'intensité de champ dans la direction de ligne ne présente pas de passage par zéro et/ou pas de maximum ou de minimum à chaque bord de détection des éléments de détection (1) qui forment la ligne de détection.

3. Dispositif de mesure selon une des revendications 1 ou 2, **caractérisé en ce que** le champ de soutien est invariant dans le temps.

4. Dispositif de mesure selon une des revendications 1 à 3, **caractérisé en ce que** la variation d'intensité de champ dans la direction de ligne présente au moins deux maximums et un minimum.

5. Dispositif de mesure selon une des revendications 1 à 4, **caractérisé en ce que** la variation d'intensité de champ dans la direction de ligne est périodique dans la région de la ligne.

6. Dispositif de mesure selon une des revendications 1 à 5, **caractérisé en ce que** la variation d'intensité de champ dans la direction de ligne présente un maximum ou un minimum au centre d'au moins un élément de détection (1), par rapport à son extension spatiale dans la direction de ligne.

7. Dispositif de mesure selon une des revendications 1 à 6, **caractérisé en ce que** le dispositif de champ de soutien présente une ligne d'aimants (5) disposés l'un à côté de l'autre, la magnétisation d'un aimant (5) étant opposée à la magnétisation de son aimant (5) voisin.

8. Dispositif de mesure selon une des revendications 1 à 6, **caractérisé en ce que** le dispositif de champ de soutien présente une ligne d'aimants (5) disposés l'un à côté de l'autre, la magnétisation d'un aimant (5) étant parallèle à la magnétisation de son aimant (5) voisin.

9. Dispositif de mesure selon la revendication 7 ou 8, **caractérisé en ce que** les aimants (5) sont directement contigus.

10. Dispositif de mesure selon une des revendications 7 à 9, **caractérisé en ce que** la ligne des aimants (5) disposés l'un à côté de l'autre est disposée, par rapport à la ligne de détection, de façon que la transition d'un aimant à l'aimant voisin ne soit pas disposée au centre d'au moins un élément de détection (1), par rapport à son extension dans la direction de ligne.

11. Dispositif de mesure selon une des revendications 1 à 10, **caractérisé en ce qu'**un seul aimant à distribution de magnétisation localement variable est utilisé.

12. Dispositif de mesure selon une des revendications 1 à 11, **caractérisé en ce que** le dispositif de champ de soutien présente des aimants permanents.

13. Dispositif de mesure selon une des revendications 1 à 12, **caractérisé par** au moins deux lignes de détection disposées l'une à côté de l'autre.

14. Dispositif de mesure selon une des revendications 1 à 13, **caractérisé par** au moins deux dispositifs de champ de soutien disposés l'un à côté de l'autre.

15. Dispositif de mesure selon une des revendications 1 à 14, **caractérisé par** au moins deux lignes de détection disposées l'une à la suite de l'autre.

16. Dispositif de mesure selon une des revendications 1 à 15, **caractérisé en ce que** les éléments de détection (1) sont disposés de façon que les signaux de détection soient déterminés par des gradients de champ locaux, générés à proximité des éléments de détection (1), mais non par des champs homogènes.

17. Dispositif de mesure selon une des revendications 1 à 16, **caractérisé en ce que** la variation d'intensité de champ dans la direction de ligne est générée sur au moins un élément de détection par un aimant qui est appliqué directement sur une puce sur laquelle l'élément de détection est disposé.

18. Procédé de fabrication d'un dispositif de mesure selon une des revendications 1 à 17, dans lequel le dispositif de champ de soutien avec une ligne d'aimants disposés l'un à côté de l'autre est aligné par rapport à la ligne de détection, **caractérisé par** la disposition d'un conducteur électrique à proximité de la ligne de détection, le conducteur électrique étant conçu de façon qu'il génère un champ quand il est parcouru par un courant, lequel champ génère dans un élément de détection de la ligne de détection un signal dépendant de la position du dispositif de champ de soutien, indépendant en première approximation de la position de la ligne de détection par rapport au conducteur électrique.
